# EUROPÄISCHE PATENTANMELDUNG

(11) **EP 1 278 069 A1**
(43) Veröffentlichungstag der Anmeldung: **22.01.2003**
(21) Anmeldenummer: 02016021.4
(22) Anmeldetag: 18.07.2002
(51) Int. Cl.: G01R 1/20, H01C 1/144, H01C 3/00

(54) **Niederohmiger Messwiderstand**

(30) Priorität: 20.07.2001 DE 10136941; 20.07.2001 DE 20112486 U
(71) Anmelder: ENSECO GmbH, 81379 München (DE)
(72) Erfinder: Meyer, Gerhard, Dr.-Ing., 16356 Eiche (DE)
(74) Vertreter: Jacoby, Georg

(57) **Zusammenfassung**

Die Erfindung betrifft niederohmige Messwiderstände mit zwei voneinander getrennten Anschlusselementen, einem Widerstandselement und Anschlussteilen aus einem elektrisch leitenden Material.

Eine U-förmige Ausbildung eines Widerstandskörpers als niederohmiger Messwiderstand besitzt insbesondere den Vorteil, dass die Richtung des fließenden elektrischen Stromes in den Schenkeln entgegengesetzt ist. Damit ist auch der aus dem elektrischen Stromfluss resultierende magnetische Fluss entgegengesetzt, so dass eine Kompensation der Magnetfelder der stromdurchflossenen Schenkel vorhanden ist. Daraus resultierende Einflüsse auf eine nachgeordnete elektrische Schaltungsanordnung werden vermieden, so dass daraus resultierende Fehler unterdrückt werden. Ein magnetisches Feld, welches Fehler verursachen könnte, entsteht nur noch um den bogenförmigen Teil des U-förmigen niederohmigen Messwiderstandes. Diese Anordnung führt vorteilhafterweise gleichzeitig dazu, dass auch Fremdfelder keine Fehlspannungen über eine Fremdinduktion einstreuen können.

## Beschreibung

Die Erfindung betrifft niederohmige Messwiderstände mit zwei voneinander getrennten Anschlusselementen, einem Widerstandselement und Anschlussteilen aus einem elektrisch leitenden Material.

Messwiderstände bekannter Bauart bestehen aus einem draht- oder blechförmig ausgebildeten Widerstandsmaterial.
Die Abgriffe zum Messen des Spannungsabfalls über den elektrischen Widerstand sind in einer ersten Variante über eine stoffliche Veränderung, z.B. Löten oder Schweißen, am elektrischen Widerstand befestigt. Dabei kommt es in der Verbindungsstelle zur Bildung von Übergangsmaterialien, deren Widerstandswert sich nichtlinear über einen längeren Zeitraum und bei Temperaturschwankungen ändert. Das führt zu Fehlern in der Messung dieses Spannungsabfalls, die mit Fehlern bei der weiteren Auswertung dieser Messergebnisse einhergehen.
Bei anderen Lösungen befinden sich die Abgriffe jeweils vor den Verbindungen zwischen dem Messwiderstand und dessen Verbindungsstelle mit den stromzu- oder stromabführenden elektrischen Leitern. Temperaturschwankungen abhängig vom fließenden elektrischen Strom und damit einhergehende Widerstandsänderungen führen zu Fehlern bei der Bestimmung des Spannungsabfalls über den Messwiderstand. Diese Fehler basieren dann auf der Nichtlinearität derartiger Widerstände.
Der elektrische Stromfluss von blechförmig ausgebildeten Messwiderstände sind durch die abzuführende Wärmemenge begrenzt.
Bei einer auf einen rohrförmigen Träger gewickelten drahtförmigen Widerstandsmaterial entsteht zusätzlich eine induktive Komponente, so dass ein nichtlinearer Widerstand vorhanden ist.
Der im Patentanspruch 1 angegebenen Erfindung liegt das Problem zugrunde, einen weitestgehend ohmschen Messwiderstand für das Messen elektrischer Ströme zu schaffen.

Dieses Problem wird mit den im Patentanspruch 1 aufgeführten Merkmalen gelöst.

Eine U-förmige Ausbildung eines Widerstandskörpers als niederohmiger Messwiderstand besitzt insbesondere den Vorteil, dass die Richtung des fließenden elektrischen Stromes in den Schenkeln entgegengesetzt ist. Damit ist auch der aus dem elektrischen Stromfluss resultierende magnetische Fluss entgegengesetzt, so dass eine Kompensation der Magnetfelder der stromdurchflossenen Schenkel vorhanden ist. Daraus resultierende Einflüsse auf eine nachgeordnete elektrische Schaltungsanordnung werden vermieden, so dass daraus resultierende Fehler unterdrückt werden. Ein magnetisches Feld, welches Fehler verursachen könnte, entsteht nur noch um den bogenförmigen Teil des U-förmigen niederohmigen Messwiderstandes. Diese Anordnung führt vorteilhafterweise gleichzeitig dazu, dass auch Fremdfelder keine Fehlspannungen über eine Fremdinduktion einstreuen können.
Formschlüssigen Verbindungen zwischen den Anschlusselementen und dem Widerstandselement des niederohmigen Messwiderstandes sind vorteilhafterweise als Pressverbindungen ausgeführt. Damit wird gewährleistet, dass weitestgehend keine stofflichen Veränderungen in den Verbindungsstellen und weitestgehend keine Nichtlinearitäten im Messwiderstand vorhanden sind. Es besteht ein linearer Zusammenhang zwischen fließenden elektrischen Strom und abgreifbarem äquivalenten Spannungsabfall zwischen den Anschlussteilen. Ein weiterer Vorteil einer derartigen Verbindung besteht darin, dass auch über einen großen Zeitraum weitestgehend keine stofflichen Veränderungen in den Verbindungsstellen stattfinden. Damit werden auch über einen großen Zeitraum gleichbleibende Messergebnisse erzielt.
Stoffschlüssige Verbindungen sind vorteilhafterweise als Schweißverbindungen durch die Verwendung des Elektronenstrahlschweißens ausgeführt. Bei Verwendung dieses Verfahrens, das unter Vakuum abläuft, sind keine Zusatzstoffe notwendig, die die Schweißnaht vor dem Luftsauerstoff schützen. Gefügeumwandlungen mit derartigen Stoffen oder Luftsauerstoff werden dadurch weitestgehend vermieden.
Die Anschlussteile als Potenzialanschlüsse sind direkt im oder am Widerstandselement des Messwiderstandes angeordnet und befinden sich zwischen den Anschlusselementen in oder an dem Widerstandselement. Die Verbindungsstellen des Widerstandselementes mit den Anschlusselementen einschließlich der stromführenden Leiter befinden sich damit außerhalb der Verbindungsstellen dieser Bestandteile des niederohmigen Messwiderstandes. Durch diesen Sachverhalt werden wiederum dadurch hervorgerufene Nichtlinearitäten weitestgehend vermieden.
Bandförmige Anschlussteile werden insbesondere aus Folien oder Tafeln hergestellt. Damit sind gleichbleibende Materialbedingungen über das Volumen des Anschlussteiles gegeben.

Vorteilhafte Ausgestaltungen der Erfindung sind in den Patentansprüchen 2 bis 13 aufgeführt.

Günstige Ausgestaltungen für das Widerstandselement des Messwiderstandes sind nach der Weiterbildung des Patentanspruchs 2 eine Platte oder ein Körper mit einem Querschnitt entweder eines Kegelschnitts, insbesondere Kreis oder Ellipse, oder Mehrecks. Eine Platte ist insbesondere für Anwendungen bei niedrigeren elektrischen Strömen bis etwa 20 A und ein Körper insbesondere für Anwendungen bei höheren elektrischen Strömen bis etwa 60 A geeignet. Ein Zylinder als Körper mit dem Querschnitt eines Kegelschnittes ist vorteilhafterweise für eine formschlüssige Verbindung mit den Anschlusselementen geeignet. Dazu ist eine Bohrung in das Anschlusselement einzubringen. Eine Platte eignet sich dagegen vorteilhafterweise für ein stoffschlüssige Verbindung.

Der niederohmige Messwiderstand nach der Weiterbildung des Patentanspruchs 3 ist insbesondere zum Messen großer fließender elektrischer Ströme geeignet. Dazu sind vorzugsweise nebeneinander zwei Anschlusselemente angeordnet, die über ein U-förmig ausgebildetes Widerstandselement überbrückt sind.
Mit einem derartigen Aufbau ist ein Bauelement mit einer geringen Breite und Tiefe gegeben. Damit eignet sich dieser niederohmige Messwiderstand insbesondere als Mehrfachwiderstand für den Einsatz in Mehrphasennetzen.
Die Anschlusselemente sind vorzugsweise als Quader realisiert, wobei die geometrischen Abmessungen je nach den zu messenden elektrischen Strömen ausführbar sind. Über bekannte lösbare Verbindungstechniken sind elektrische Leitungen entsprechender Querschnitte mit den Quadern als Anschlusselemente leicht kontaktierbar.

Ein Widerstandselement mit einem kreisförmigen oder überwiegend kreisförmigen Querschnitt nach der Weiterbildung des Patentanspruchs 4 führt zu einer relativ großen Fläche, so dass damit ein kleiner elektrischer Widerstand realisierbar ist. Erwärmungen vor allem bei großen elektrischen Strömen werden minimiert. Weiterhin bietet ein derartiger Querschnitt den Vorteil, dass eine große Kontaktfläche zwischen den Anschlusselementen und dem insbesondere eingepressten Widerstandselement vorhanden ist. Die Berührungsfläche ist leicht durch die Länge der Schenkel des Widerstandselementes und der Tiefe der das Widerstandselement aufnehmenden Öffnungen in den Anschlusselementen vorbestimmbar. Eine große Berührungsfläche sichert einen geringen elektrischen Widerstand zwischen den Anschlusselementen und dem Widerstandselement.
Mit formschlüssigen Verbindungen werden Stoffumwandlungen in den Verbindungsstellen weitestgehend vermieden.

Die Weiterbildung des Patentanspruchs 5 führt zu einer Presspassung zwischen den Anschlusselementen und dem Widerstandselement. Dadurch wird sowohl eine feste Verbindung der Elemente als auch ein geringer elektrischer Widerstand zwischen den Elementen sichergestellt.

Eine größere Härte des Materials des Anschlusselmentes gegenüber der des Widerstandselementes nach der Weiterbildung des Patentanspruchs 6 führt dazu, dass über einen längeren Zeitraum das weichere Material um das härtere fließt. Dadurch hervorgerufene geometrische Veränderungen, die mit Veränderungen des elektrischen Widerstandes einhergehen, werden weitestgehend vermieden. Messfehler, die aus diesen Veränderungen resultieren, werden damit weitestgehend vermieden.

Die Realisierung des Anschlusselementes nach der Weiterbildung des Patentanspruchs 7 als Körper der im Querschnitt L-förmig ausgebildet ist bietet weiterhin den Vorteil, dass der horizontale Schenkel als Verbindungsteil der stromführenden Leiter nutzbar ist. Mit der Verwendung einer Feder- oder einer Schraubenanordnung sind die unterschiedlichsten Verbindungsvarianten realisierbar. Günstige Varianten sind durch die Anwendung einer Klemme in Verbindung mit einer Schraubenverbindung oder einer über eine Feder wirkende Klemmverbindung gegeben. Ein weiterer Vorteil besteht darin, dass die vertikal angeordnete Oberfläche des Anschlusselementes gleichzeitig als Anschlag für die stromführenden Leiter nutzbar ist.

Über eine Öffnung im Widerstandselement nach der Weiterbildung des Patentanspruchs 8 lässt sich dieses vorteilhaft kalibrieren. Die geometrischen Abmessungen der Öffnung bestimmen die Größe des elektrischen Widerstandes des Widerstandselementes und damit des niederohmigen Messwiderstandes. Die Öffnung wird vorteilhafterweise gebohrt.

Eine Befestigung durch eine nachträgliche plastische Verformung von Öffnungen im Widerstandselement nach der Platzierung der Endenbereiche des draht- oder bandförmigen Anschlussteils nach der Weiterbildung des Patentanspruchs 9 führt dazu, dass der Einsatz zusätzlicher Materialien oder Stoffumwandlungen in den Verbindungsstellen und dadurch hervorgerufene Nichtlinearitäten der Widerstandscharakteristika weitestgehend vermieden werden. Ein besonders fester Halt wird bei der Befestigung von bandförmigen Anschlussteilen in runden Öffnungen erzielt.
Dabei werden die Öffnungen in das Widerstandselement vorteilhafterweise gebohrt oder gestochen.

Die Endenbereiche der draht- oder bandförmigen Anschlussteile sind nach der Weiterbildung des Patentanspruchs 10 vorteilhafterweise auf das Widerstandselement geschweißt. Dabei sind insbesondere Schweißverfahren anwendbar, bei denen ohne Zusatzwerkstoffe eine feste Verbindung erzielt wird. Derartige Schweißverfahren sind unter anderem das elektrische Punkt-, das Ultraschall-, das Laserstrahl- oder das Elektronenstrahlschweißen. Damit werden Nichtlinearitäten im Widerstandsverhalten des niederohmigen Messwiderstandes minimiert.

Gleiche Materialien für das Widerstandselement und die Anschlussteile nach der Weiterbildung des Patentanspruchs 11 sichern einen geringen elektrischen Widerstand zwischen dem Widerstandselement und den Anschlussteilen auch und vor allem über einen langen Zeitraum.

Materialumwandlungen durch die thermischen Einflüsse des fließenden elektrisches Stromes im Widerstandselement werden damit weitestgehend vermieden.
Die Realisierung der rohrförmigen Anschlüsse vorzugsweise in Kupfer garantiert eine leichte und bekannte Kontaktierung des niederohmigen Messwiderstands von außen.

Mehrere erfindungsgemäße niederohmige Messwiderstände eignen sich insbesondere zur Verwendung in Mehrphasennetzen. Eine Anordnung der niederohmigen Messwiderstände nebeneinander nach der Weiterbildung des Patentanspruchs 12, wobei die Schenkel der U-förmig ausgebildeten Widerstandselemente in einer Ebene liegen, ist eine raumsparende Variante für den Einsatz in Mehrphasennetzen.

Ein Verguss mehrerer niederohmiger Messwiderstände nach der Weiterbildung des Patentanspruchs 13 ergibt ein kompaktes Bauteil, das leicht handzuhaben ist. Handhaben bedeutet dabei insbesondere Transport, Lagerung und Einbau in ein Gerät.

Ausführungsbeispiele der Erfindung sind in den Zeichnungen dargestellt und werden im folgenden näher beschrieben.
Es zeigen:
- Fig. 1: ein niederohmiger Messwiderstand mit wenigstens einem plattenförmigen Widerstandselement,
- Fig. 2: ein niederohmiger Messwiderstand mit einem U-förmig ausgebildeten Widerstandselement mit einem kreisförmigen Querschnitt in einer Vorder- und einer Seitenansicht und
- Fig. 3: eine prinzipielle Darstellung eines niederohmigen Messwiderstandes für den Einsatz in einem Dreiphasennetz.

### 1. Ausführungsbeispiel

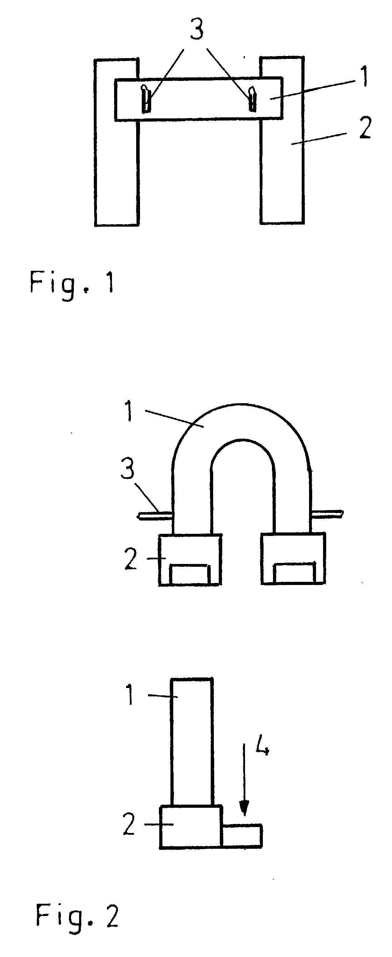

Ein niederohmiger Messwiderstand mit einem U-förmig ausgebildeten Widerstandskörper besteht in einem ersten Ausführungsbeispiel aus einem Widerstandselement 1, zwei Anschlusselementen 2 und zwei Anschlussteilen 3 (Darstellung in der Fig. 1). Das Widerstandselement 1 und die Anschlusselemente 2 sind plattenförmige Teile, die so miteinander verbunden sind, dass eine U-Form vorhanden ist (Fig. 1). Der so ausgestaltete niederohmige Messwiderstand ist insbesondere zum Messen kleinerer elektrischer Ströme bis etwa 20 A geeignet.
Die die Schenkel der U-Form bildenden plattenförmigen Teile sind die Anschlusselemente 2, mit denen der niederohmige Messwiderstand zum Einen mit dem elektrischen Netz und zum Anderen mit dem elektrischen Verbraucher elektrisch leitend und lösbar verbindbar ist. Diese bestehen aus verzinnten Kupfer. Das den Mittelteil der U-Form bildende plattenförmige Teil ist das Widerstandselement 1 als eigentlicher niederohmiger Messwiderstand. Dieser besteht aus einer Kupferlegierung. Die plattenförmigen Teile sind über elektronenstrahlgeschweißte Verbindungen befestigt. Jeweils ein Endenbereich der Anschlussteile 3 als Potenzialanschlüsse sind auf dem Widerstandselement 1 befestigt. Diese sind draht- oder bandförmig ausgebildet.
In einer Ausführungsform besitzt das Widerstandselement 1 eine Bohrung als Öffnung, wobei die manuelle oder maschinelle Handhabbarkeit nicht wesentlich verringert wird. Ein kleiner elektrischer Widerstand führt zu kleineren Verlusten in Form von Wärme. Ein weiterer Vorteil der Öffnung ist die damit verbundene Möglichkeit einer Kalibrierung des niederohmigen Messwiderstandes über die geometrischen Abmessungen der Öffnung. Die Anschlussteile 3 als Potenzialanschlüsse befinden sich in Nähe der Öffnung.

### 2. Ausführungsbeispiel

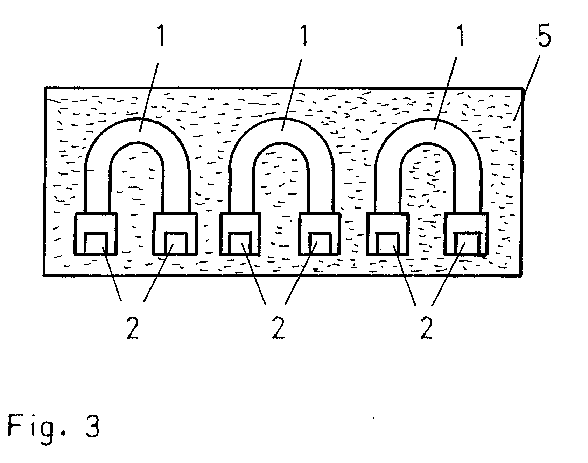

Ein niederohmiger Messwiderstand besteht in einem zweiten Ausführungsbeispiel aus zwei Anschlusselementen 2 aus einem eine hohe elektrische Leitfähigkeit aufweisenden Material, einem Widerstandselement 1 aus einem Material mit einem elektrischen Widerstand und zwei Anschlussteilen 3 (Darstellung in der Fig. 2). Ein derartig realisierter niederohmiger Messwiderstand ist insbesondere zum Messen großer fließender elektrischer Ströme geeignet.
Ein Anschlusselement 2 ist ein Körper mit einem L-förmigen Querschnitt. Der horizontale Teil stellt ein Teil einer Klemmverbindung für den Stromanschluss dar. Die Klemmverbindung ist durch eine Klemme 4 mit einer Schraube oder einer Feder als Klemmelement realisiert. In der Fig. 2 ist das nur durch den Pfeil dargestellt, da eine derartige Anordnung allgemein bekannt ist. Der andere Teil des Anschlusselementes 2 ist ein Quader. Die zum horizontalen Teil weisende Oberfläche ist gleichzeitig der Anschlag für den Stromanschluss.
Zwei derartig ausgebildete Anschlusselemente 2 sind nebeneinander angeordnet und über ein Widerstandselement 1 miteinander verbunden. Das Widerstandselement 1 ist U-förmig ausgebildet und besitzt einen kreisförmigen Querschnitt. Es ist so in den Quadern der Anschlusselemente 2 eingebracht, dass der horizontale Teil und ein Schenkel einen rechten Winkel einschließen. Die Endenbereiche der Schenkel des U-förmigen Widerstandselementes 1 sind über formschlüssige Verbindungen hervorgerufen durch eine elastische Verformung in den Anschlusselementen 2 befestigt. Dazu ist einer der Verbindungspartner unter- oder übermaßig ausgeführt, so dass eine Presspassung vorhanden ist.
In einer ersten Ausführungsform sind im Widerstandselement 1 mit einem Abstand zueinander zwei gebohrte oder gestochene Öffnungen eingebracht. In den Öffnungen ist jeweils ein Endenbereich eines draht- oder bandförmigen Anschlussteiles 3 platziert. Die Anschlussteile 3 sind durch eine nachträgliche plastische Verformung im Widerstandselement 1 befestigt.
In einer zweiten Ausführungsform sind auf dem Widerstandselement 1 mit einem Abstand zueinander jeweils ein Endenbereich der draht- oder bandförmigen Anschlussteile 3 als Potenzialanschlüsse befestigt.
Das Widerstandselement 1 und die Anschlussteile 3 bestehen aus dem gleichen Material.
Für Einphasennetze kommt ein derartiger niederohmiger Messwiderstand zum Einsatz.
Bei Mehrphasennetzen werden niederohmige Messwiderstände entsprechend der Anzahl der Phasen verwendet. Diese sind dabei vorteilhafterweise so platziert, dass die horizontalen Teile der Anschlusselemente 2 parallel zueinander angeordnet sind und in eine Richtung zeigen. Die niederohmigen Messwiderstände sind zu einem Bauteil 5 vergossen. Die Fig. 3 zeigt ein derartiges Bauteil 5 für den Einsatz in einem Dreiphasennetz.

## Patentansprüche

1. Niederohmiger Messwiderstand mit zwei voneinander getrennten Anschlusselementen, einem Widerstandselement und Anschlussteilen aus einem elektrisch leitenden Material, **dadurch gekennzeichnet, dass** das Widerstandselement (1) ein U-förmig ausgebildeter Widerstandskörper ist, dass die beiden Anschlusselemente (2) des Messwiderstandes und das Widerstandselement (1) über form- und/oder stoffschlüssige Verbindungen miteinander elektrisch leitend verbunden sind und dass mit einem Abstand zueinander entweder im oder am Widerstandselement (1) jeweils ein Endenbereich von zwei draht- oder bandförmigen Anschlussteilen (3) befestigt sind.

2. Niederohmiger Messwiderstand nach Patentanspruch 1, **dadurch gekennzeichnet, dass** das Widerstandselement (1) des Messwiderstandes eine Platte, ein Körper mit dem Querschnitt eines Kegelschnittes oder ein Körper mit einem mehreckigen Querschnitt ist.

3. Niederohmiger Messwiderstand nach Patentanspruch 1, **dadurch gekennzeichnet, dass** die Endenbereiche des Widerstandselementes (1) mit durch elastische Verformungen hervorgerufenen formschlüssigen Verbindungen mit den Anschlusselementen (2) verbunden sind und dass mit einem Abstand zueinander entweder im oder am Widerstandselement (1) jeweils ein Endenbereich von zwei draht- oder bandförmigen Anschlussteilen (3) so verbunden sind, dass gegeneinander thermospannungsfreie Elemente vorhanden sind.

4. Niederohmiger Messwiderstand nach den Patentansprüchen 1 bis 3, **dadurch gekennzeichnet, dass** das Widerstandselement (1) einen kreisförmigen oder überwiegend kreisförmigen Querschnitt aufweist.

5. Niederohmiger Messwiderstand nach Patentanspruch 4, **dadurch gekennzeichnet, dass** der Querschnitt des Anschlusselementes (2) im Bereich der Verbindung zwischen Anschlusselement (2) und Widerstandselement (1) in allen Abmessungen größer als der des Widerstandselementes (1) ist.

6. Niederohmiger Messwiderstand nach Patentanspruch 5, **dadurch gekennzeichnet, dass** das Material des Anschlusselementes (2) eine größere Härte als das des Widerstandselementes (1) besitzt.

7. Niederohmiger Messwiderstand nach Patentanspruch 1, **dadurch gekennzeichnet, dass** das Anschlusselement (2) ein Körper mit einem L-förmigen Querschnitt ist, dass der horizontale Teil ein erster Teil einer Klemmverbindung des Stromanschlusses ist und dass der vertikale Teil eine Aufnahme des Endenbereichs des Widerstandselementes (1) und Anschlag des Stromanschlusses ist.

8. Niederohmiger Messwiderstand nach Patentanspruch 1, **dadurch gekennzeichnet, dass** das plattenförmige Widerstandselement (1) eine der Kalibrierung dienende Öffnung aufweist.

9. Niederohmiger Messwiderstand nach Patentanspruch 1, **dadurch gekennzeichnet, dass** mit einem Abstand im Widerstandselement (1) jeweils eine Öffnung eingebracht ist und dass jeweils ein Endenbereich des draht- oder bandförmigen und durch eine nachträgliche plastische Verformung befestigten Anschlussteils (3) in der Öffnung angeordnet ist.

10. Niederohmiger Messwiderstand nach Patentanspruch 1, **dadurch gekennzeichnet, dass** mit einem Abstand jeweils ein draht- oder bandförmiges Anschlussteil (3) auf das Widerstandselement (1) geschweißt ist.

11. Niederohmiger Messwiderstand nach Patentanspruch 1, **dadurch gekennzeichnet, dass** das Widerstandselement (1) und die Anschlussteile (3) aus dem gleichen Material bestehen.

12. Niederohmiger Messwiderstand nach Patentanspruch 1, **dadurch gekennzeichnet, dass** mehrere niederohmige Messwiderstände nebeneinander angeordnet sind.

13. Niederohmiger Messwiderstand nach Patentanspruch 12, **dadurch gekennzeichnet, dass** die niederohmigen Messwiderstände Bestandteile eines vergossenen Bauteils (5) oder selbst ein Bauteil sind.
